# EUROPÄISCHE PATENTSCHRIFT

(11) **EP 2 928 844 B1**
(45) Veröffentlichungstag und Bekanntmachung des Hinweises auf die Patenterteilung: **12.06.2019**
(21) Anmeldenummer: 13811142.2
(22) Anmeldetag: 05.12.2013
(51) Int. Cl.: C04B 37/02, H01L 23/373, H01L 23/15, H01L 21/48

(54) **VERFAHREN ZUR HERSTELLUNG VON SUBSTRATEN FÜR HALBLEITERBAUELEMENTE**
PROCESS FOR PRODUCING SUBSTRATES FOR SEMICONDUCTOR COMPONENTS
PROCÉDÉ DE PRÉPARATION DE SUBSTRATS POUR DES COMPOSANTS SEMI-CONDUCTEURS

(30) Priorität: 07.12.2012 DE 102012024063
(43) Veröffentlichungstag der Anmeldung: 14.10.2015
(73) Patentinhaber: IXYS Semiconductor GmbH, D-68623 Lampertheim (DE)
(72) Erfinder: ZSCHIESCHANG, Olaf, 85591 Vaterstten (DE); KNOLL, Heiko, 35037 Marburg (DE)
(74) Vertreter: Duxbury, Stephen
(86) Internationale Anmeldenummer: PCT/EP2013/075727
(87) Internationale Veröffentlichungsnummer: WO 2014/086950

(56) Entgegenhaltungen:
- EP-A2- 2 530 707
- JP-A- S6 338 244
- US-A1- 2001 031 345
- US-A1- 2004 195 294

## Beschreibung

Die Erfindung betrifft ein Verfahren zur Herstellung von metallisierten Metall-Keramik-Substraten als Schaltungsträger, insbesondere für Leistungshalbleiter-Bauelemente oder Leistungshalbleiter-Module. Der Erfindung bezieht sich auf den Schaltungsträger als solchen, der auf einen Kühlkörper montiert werden kann.

Ein- oder doppelseitig metallisierte Metall-Keramik-Substrate sind allgemein bekannt. Derartige Metall-Keramik-Substrate finden insbesondere im Bereich von Leistungshalbleitermodulen als Schaltungsträger Verwendung. Es handelt sich bei den Schaltungsträgern um eine auf Ober- und Unterseite mit einer Cu-Metallisierung versehene Keramik, bei der mindestens eine metallisierte Seite eine schaltungstechnische Struktur aufweist. Das bekannte Verfahren zum Herstellen dieses Metall-Keramik-Verbundes mittels eutektischen Bondens wird allgemein als Direct-Bonding-Prozess bezeichnet (Direct-Copper-Bonding DCB).

Die US 3,994,430 und die EP 0 085 914 beschreiben ein Verfahren zur Herstellung von Metall-Keramik-Substraten nach dem Direct-Bonding-Prozess. Den bekannten Herstellungsverfahren ist gemeinsam, dass die Verbindungsbildung zwischen Metallplatte oder -folie einerseits und Keramiksubstrat andererseits durch einen Flüssigphasen-Bondprozess erfolgt, bei dem eine auf die Metallplatte aufgetragene Zwischenschicht aufgeschmolzen wird, deren Schmelzpunkt (Eutektikum) unterhalb des Schmelzpunktes des Metalls und der Keramik liegt.

Der bekannte Direct-Bonding-Prozess hat sich in der Praxis bewährt. Als nachteilig erweisen sich aber die mechanischen Spannungen, die auf Grund der unterschiedlichen Temperaturkoeffizienten der miteinander verbundenen Materialien entstehen. Zur Verbesserung der Leitfähigkeit und Stromtragfähigkeit sollten die Kupferplatten oder - folien, die auf das Keramiksubstrat aufgebracht werden, eine möglichst große Schichtdicke aufweisen. Mit zunehmender Schichtdicke nehmen aber die mechanischen Spannungen noch zu.

Neben den DCB (Direct-Copper-Bonding)-Substraten sind auch Keramiksubstrate bekannt, die mit einer Aluminiumschicht metallisiert sind. Im Vergleich zu dem DCB-Verfahren erfordert die Herstellung dieser Metall-Keramik-Substrate deutlich geringere Prozesstemperaturen. Während bei dem DCB-Verfahren die Prozesstemperatur zwischen 1.000 und 1.100 °C liegt, wird die mit einer Aluminium-Silizium-Schicht beschichtete Aluminiumplatte oder -folie bei einer Prozesstemperatur auf das Keramik-Substrat aufgeschmolzen, die zwischen 600 und 700 °C liegt.

Aus der EP 2 530 707 A2 ist ein Verbund von einem metallisierten Metall-Keramik-Substrat (Schaltungsträger) und einem Metallkörper bekannt. Der Schaltungsträger soll bei der EP 2 530 707 A2 nach dem bekannten DCB- oder DAB-Prozess hergestellt werden. Der EP 2 530 707 A2 liegt die Aufgabe zugrunde, ein metallisiertes Metall-Keramik-Substrat mit einem Metallkörper zu verbinden der die während des Betriebs entstehende Wärme ableiten soll. Folglich ist der Metallkörper ein Kühlkörper, der aus Aluminium oder Kupfer bestehen kann.

Die US 2001/0031345 A1 beschreibt ein Verfahren zur Herstellung eines Schaltungsträgers. Die US 2001/0031345 A1 offenbart ein Ausführungsbeispiel (EXAMPLE 1), bei dem ein Keramik-Substrat und eine Bodenplatte bereitgestellt werden. Die Bodenplatte wird an der Oberseite mit einer Ni-B Beschichtung (1 µm) und das Keramik-Substrat wird an der Ober- und Unterseite mit einer Ni-B Beschichtung (1µm) versehen. Auf die Oberseite der Bodenplatte wird eine weitere Schicht aus Ni-B beschichteten SiC-Partikeln aufgebracht, und anschließend wird Druck aufgebracht. Daraufhin wird auf die Bodenplatte eine Al-10Si-1.5Mg-Schicht aufgelegt und darauf wird das Keramik-Substrat aufgelegt. Auf die Oberseite des Pakets wird wieder eine weitere Schicht aus Schicht aus Ni-B beschichteten SiC-Partikeln aufgebracht, und anschließend wird wieder Druck aufgebracht.

Daraufhin wird auf die Oberseite des Pakets eine weitere Al-10Si-1.5Mg-Schicht aufgelegt und auf die Oberseite der Al-10Si-1.5Mg-Schicht wird eine Kupfer-Folie aufgelegt. Das Paket wird nunmehr im Vakuum in einem Ofen bei einer Prozesstemperatur von 700°C erhitzt und anschließend abgekühlt. Folglich umfasst das Verfahren zur Herstellung eines Schaltungsträgers den Verfahrensschritt des Auflegens einer Al-10Si-1.5Mg-Schicht auf die Oberseite eines beidseitig beschichteten und mit einer weiteren Schicht versehenen Keramik-Substrats und aus Auflegen einer Kupfer-Folie auf die auf dem Keramik-Substrat liegende Al-10Si-1.5Mg-Schicht.

Der Erfindung liegt die Aufgabe zu Grunde, die mechanischen Spannungen in dem Verbund von Trägersubstrat und Metallisierung bei der Herstellung von metallisierten Metall-Keramik-Substraten (Schaltungsträger) zu verringern.

Die Lösung dieser Aufgabe erfolgt erfindungsgemäß mit den Merkmalen des Patentanspruchs 1. Die Unteransprüche betreffen bevorzugte Ausführungsformen der Erfindung.

Das erfindungsgemäße Verfahren zeichnet sich dadurch aus, dass eine Aluminium-Magnesium-Schicht AlMg oder Aluminium-Silizium-Schicht AISi auf eine Kupferplatte oder -folie aufgebracht wird, wobei die beschichtete Kupferplatte oder -folie mit einer Prozesstemperatur stoffschlüssig mit einem Keramiksubstrat verbunden wird, die deutlich unterhalb der Prozesstemperatur des bekannten DCB (Direct-Copper-Bonding)-Verfahrens liegt.

Zur Ausbildung der Leiterbahnen für den Schaltungsträger wird die Kupferplatte oder - folie vor dem Auflegen auf das Keramik-Substrat strukturiert. Es ist aber auch möglich, die beschichtete Kupferplatte oder -folie im Verbund mit dem Keramik-Substrat zu strukturieren. In diesem Fall erweist sich aber der Ätzprozess als komplizierter, da die Aluminium-Silizium-Schicht in einem zusätzlichen Ätzschritt aus den Gräben entfernt werden muss.

Die Kupferplatte oder -folie wird vorzugsweise mittels Laserschneiden oder mittels Stanzen strukturiert. Dabei können zusammenhängende Bereiche bis auf einen Steg abgetrennt und aus der Platten- bzw. -folienebene herausgedrückt und danach einfach beispielsweise durch Fräsen oder Schleifen abgetrennt werden.

Der relativ aufwändige Prozess der Voroxidation der Kupfer-Bleche entfällt bei dem erfindungsgemäßen Verfahren.

Auf Grund der relativ geringen Prozesstemperatur sind die mechanischen Spannungen infolge der unterschiedlichen Temperaturkoeffizienten der miteinander verbundenen Materialien geringer als bei dem Verbund von einem Keramik-Substrat und einer oxidierten Kupferplatte oder -folie nach dem DCB-Verfahren. Andererseits verfügt das nach dem erfindungsgemäßen Verfahren hergestellte Metall-Keramik-Substrat über verbesserte elektrische Eigenschaften gegenüber dem bekannten Verbund von Keramik-Substrat und Aluminiumplatte oder -folie, die mit einer Aluminium-Silizium-Schicht beschichtet ist.

Darüber hinaus erlaubt das erfindungsgemäße Verfahren im Vergleich zu dem DCB-Verfahren bei gleichen mechanischen Spannungen den stoffschlüssigen Verbund von Keramik-Substraten und Kupferplatten oder -folien, die eine größere Schichtdicke aufweisen. Damit verfügen die nach dem erfindungsgemäßen Verfahren hergestellten Metall-Keramik-Substrate im Vergleich zu den DCB-Substraten über verbesserte elektrische Eigenschaften, insbesondere eine höhere Stromleitfähigkeit und Stromtragfähigkeit.

Bei dem erfindungsgemäßen Verfahren ist es ausreichend, das Keramiksubstrat mit der aufliegenden Kupferplatte oder -folie auf eine Prozesstemperatur zu erhitzen, die zwischen 500 und 800 °C, vorzugsweise zwischen 600 und 700 °C liegt. Insbesondere sollte die Prozesstemperatur bei etwa 600 °C liegen.

Für das erfindungsgemäße Verfahren ist grundsätzlich unerheblich, wie die Aluminium-Magnesium-Schicht oder Aluminium-Silizium-Schicht auf die Kupferplatte oder -folie aufgebracht wird. Eine Oxidation der Materialien bei hohen Prozesstemperaturen ist jedenfalls nicht erforderlich.

Die Aluminium-Magnesium-Schicht oder Aluminium-Silizium-Schicht wird auf die Kupferplatte oder -folie unter Druck aufgebracht, wobei die Materialien erwärmt werden können. Besonders bevorzugt wird die Aluminium-Magnesium-Schicht oder Aluminium-Silizium-Schicht auf die Kupferplatte oder -folie mittels Walzplattieren aufgebracht. Es können aber auch andere Verfahren angewandt werden. Beispielsweise kann die Aluminium-Magnesium-Schicht oder Aluminium-Silizium-Schicht mit einem vakuumbasierten Beschichtungsverfahren aufgebracht werden.

Die Vorteile des nach dem erfindungsgemäßen Verfahren hergestellten Keramik-Substrats liegen in der Kombination der hohen Wärmeleitfähigkeit des Keramik-Trägers einerseits und der hohen Leit- und Stromtragfähigkeit der Kupferbeschichtung andererseits.

Das Keramik-Substrat kann ein Al₂O₃-Substrat oder ein Si₃N₄-Substrat oder ein AlN-Substrat sein.

Die beschichteten Kupferplatten oder -folien können auf eine oder beide Seiten des Metall-Keramik-Substrats aufgebracht werden, um einseitig oder doppelseitig metallisierte Schaltungsträger herzustellen.

Zur Herstellung von doppelseitig metallisierten Keramik-Substraten ist das erfindungsgemäße Verfahren insofern von Vorteil, als nicht die Gefahr besteht, dass das Kupfer bei den niedrigeren Prozesstemperaturen im Vergleich zum DCB-Verfahren auf dem Träger aufschmilzt.

Im Folgenden wird ein Ausführungsbeispiel der Erfindung unter Bezugnahme auf die Figuren näher erläutert.

Es zeigen:

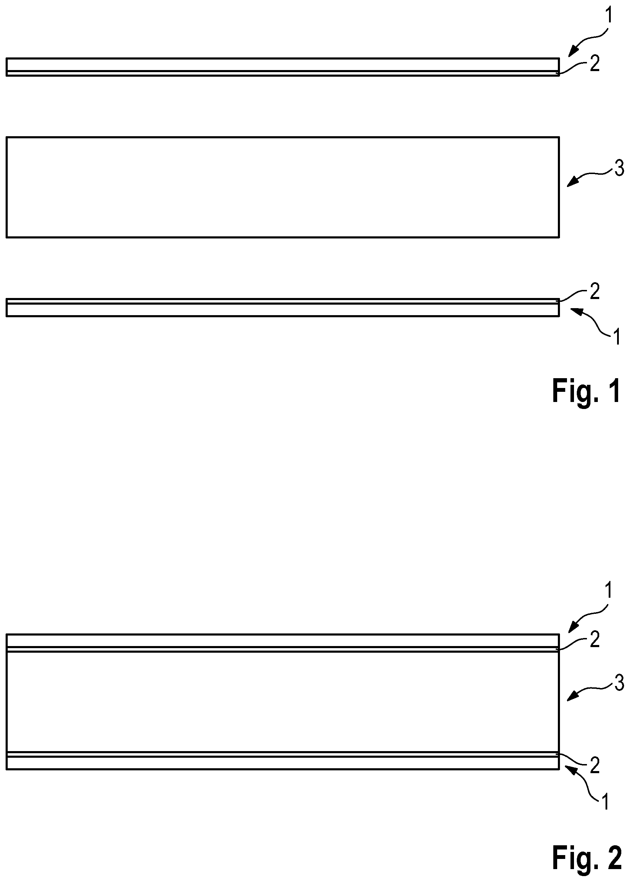

- Fig. 1: mit einer Aluminium-Magnesium-Schicht oder Aluminium-Silizium-Schicht beschichtete Kupfer-Platten zusammen mit einem Keramik-Substrat in geschnittener Darstellung vor der stoffschlüssigen Verbindung zu einem doppelseitig metallisierten Metall-Keramik-Substrat und
- Fig. 2: einen Schnitt durch das doppelseitige Metall-Keramik-Substrat.

Zur Herstellung des erfindungsgemäßen Metall-Keramik-Substrats wird eine Kupferplatte oder -folie 1, die nachfolgend als Kupfer-Platte 1 bezeichnet wird, mit einer Aluminium-Magnesium-Schicht AlMg 2 oder Aluminium-Silizium-Schicht AISi 2 beschichtet. Die AlMg-Schicht oder AlSi-Schicht wird mittels Plattieren auf die Kupfer-Platte aufgebracht. Beim Walzplattieren werden die Materialien bei einer vorgegebenen Temperatur unter einem vorgegebenen Druck miteinander verbunden.

Bei der Kupferplatte 1 handelt es sich vorzugsweise um eine Platte, die zur Bildung von Leiterbahnen bereits strukturiert ist. Die Strukturierung kann mit den bekannten Verfahren, insbesondere mittels Laserschneiden oder Stanzen erfolgen.

In einem zweiten Prozessschritt wird die mit der AlMg-Schicht oder AlSi-Schicht 2 beschichtete Kupfer-Platte 1 mit der beschichteten Seite auf ein Keramik-Substrat 3, beispielsweise ein Al₂O₃-Substrat, ein Si₃N₄-Substrat oder ein AlN-Substrat aufgelegt. Das Keramik-Substrat 3 wird zusammen mit der beschichteten Kupfer-Platte daraufhin auf eine Prozesstemperatur von etwa 600 °C erhitzt. Hierzu durchläuft der Verbund 1, 2, 3 auf einem Transportband einen Durchlaufofen. Nach dem Durchlaufen durch den Ofen wird der Verbund wieder auf Raumtemperatur abgekühlt. Für die Herstellung eines doppelseitigen Metall-Keramik-Substrats werden mit der AlMg-Schicht oder AlSi-Schicht 2 beschichtete Kupfer-Platten 1 auf die Ober- und Unterseite des Keramik-Substrats 3 aufgebracht.

Während der Verbund 1, 2, 3 den Ofen durchläuft, schmilzt die AlMg- oder AlSi-Schicht 2 bei der Prozesstemperatur auf, so dass die Kupfer-Platte 1 stoffschlüssig mit dem Keramik-Substrat 3 zu dem Schaltungsträger verbunden werden, der sich einerseits durch relativ geringe mechanische Spannungen und andererseits durch eine hohe Leitfähigkeit und Stromtragfähigkeit auszeichnet. Der erfindungsgemäße Schaltungsträger ist dazu bestimmt, auf einen Kühlkörper montiert zu werden, um die Wärme von dem metallisierten Metall-Keramik-Substrat ableiten zu können.

## Patentansprüche

1. Verfahren zur Herstellung von metallisierten Metall-Keramik-Substraten als Schaltungsträger, insbesondere für Leistungshalbleiter-Bauelemente oder Leistungshalbleiter-Module mit folgenden Verfahrensschritten:
Aufbringen einer Aluminium-Magnesium-Schicht (2) oder einer Aluminium-Silizium-Schicht (2) auf eine Kupfer-Platte oder Kupfer-Folie (1), wobei die Aluminium-Magnesium-Schicht oder Aluminium-Silizium-Schicht auf die Kupfer-Platte oder -folie unter Druck aufgebracht wird,
Auflegen der Kupfer-Platte oder -folie mit der beschichteten Seite auf ein Keramiksubstrat (3),
Erhitzen des Keramiksubstrats mit der aufliegenden Kupfer-Platte oder -folie auf eine Prozesstemperatur, so dass sich die Kupfer-Platte oder -folie mit dem Keramiksubstrat stoffschlüssig verbindet, und
Abkühlen des Verbundes von Keramiksubstrat und Kupfer-Platte oder -folie auf Raumtemperatur, wobei
die Kupfer-Platte oder -folie zur Ausbildung der Leiterbahnen für den Schaltungsträger vor dem Auflegen auf das Keramik-Substrat strukturiert wird oder im Verbund mit dem Keramik-Substrat strukturiert wird.

2. Verfahren nach Anspruch 1, **dadurch gekennzeichnet, dass** die Aluminium-Magnesium-Schicht oder Aluminium-Silizium-Schicht auf die Kupfer-Platte oder - folie mittels Walzplattieren aufgebracht wird.

3. Verfahren nach Anspruch 1 oder 2, **dadurch gekennzeichnet, dass** die Prozesstemperatur, auf die das Keramiksubstrat mit der aufliegenden Kupfer-Platte oder -folie erhitzt wird, zwischen 500 und 800 ° C, vorzugsweise zwischen 600 und 700 ° C, insbesondere 600 °C liegt.

4. Verfahren nach Anspruch 3, **dadurch gekennzeichnet, dass** die Kupfer-Platte oder - folie mittels Laserschneiden oder mittels Stanzen strukturiert wird.

5. Verfahren nach einem der Ansprüche 1 bis 4, **dadurch gekennzeichnet, dass** das Keramik-Substrat ein Al₂O₃-Substrat oder ein Si₃N₄-Substrat oder ein AlN-Substrat ist.

6. Verfahren nach einem der Ansprüche 1 bis 5, **dadurch gekennzeichnet, dass** zur Herstellung von doppelseitig metallisierten Metall-Keramik-Substraten mit einer Aluminium-Magnesium-Schicht oder Aluminium-Silizium-Schicht beschichtete Kupfer-Platten oder -folien mit den beschichteten Seiten auf beide Seiten des Keramiksubstrats aufgebracht werden.

7. Verfahren nach einem der Ansprüche 1 bis 6, **dadurch gekennzeichnet, dass** eine Aluminium-Silizium-Schicht (2) auf die Kupfer-Platte oder Kupfer-Folie (1) aufgebracht wird.

8. Verfahren nach einem der Ansprüche 1 bis 6, **dadurch gekennzeichnet, dass** eine Aluminium-Magnesium-Schicht (2) auf die Kupfer-Platte oder Kupfer-Folie (1) aufgebracht wird.

## Claims

1. Process for producing metallised metal-ceramic substrates as circuit carriers, in particular for power semiconductor components or power semiconductor modules, comprising the following process steps:
applying an aluminium-magnesium layer (2) or an aluminium silicon layer (2) to a copper plate or copper foil (1), wherein the aluminium-magnesium layer or aluminium-silicon layer is applied under pressure to the copper plate or foil,
placing the copper plate or foil with the coated side on a ceramic substrate (3),
heating the ceramic substrate with the placed copper plate or foil to a process temperature so that the copper plate or foil adhesively bonds to the ceramic substrate, and
cooling the composite of ceramic substrate and copper plate or foil to room temperature,
wherein the copper plate or foil is structured to form conductor tracks for the circuit carrier before being placed on the ceramic substrate or is structured in conjunction with the ceramic substrate.

2. Method according to claim 1, **characterised in that** the aluminium-magnesium layer or aluminium-silicon layer is applied to the copper plate or foil by means of roll cladding.

3. Method according to claim 1 or 2, **characterised in that** the process temperature to which the ceramic substrate together with the applied copper plate or foil is heated is between 500 and 800°C, preferably between 600 and 700°C, in particular is 600°C.

4. Method according to claim 3, **characterised in that** the copper plate or foil is structured by means of laser cutting or by means of punching.

5. Method according to claims 1 to 4, **characterised in that** the ceramic substrate is an Al₂O₃ substrate or an Si₃N₄ substrate or an AlN substrate.

6. Method according to claims 1 to 5, **characterised in that** in order to produce double-sided metallised metal-ceramic substrates, copper plates or foils coated with an aluminium-magnesium layer or aluminium-silicon layer are applied with the coated sides to both sides of the ceramic substrate.

7. Method according to claims 1 to 6, **characterised in that** an aluminium-silicon layer (2) is applied to the copper plate or copper foil (1).

8. Method according to claims 1 to 6, **characterised in that** an aluminium-magnesium layer (2) is applied to the copper plate or copper foil (1).

## Revendications

1. Procédé pour la fabrication de substrats métal-céramique métallisés servant de support de circuit, notamment pour des composants électroniques semi-conducteurs de puissance ou des modules semi-conducteurs de puissance, comprenant les étapes suivantes :
application d'une couche d'aluminium-magnésium (2) ou d'une couche d'aluminium-silicium (2) sur une plaque de cuivre ou une feuille de cuivre (1), la couche d'aluminium-magnésium ou d'aluminium-silicium étant appliquée sous pression sur la plaque ou feuille de cuivre,
application de la plaque ou feuille de cuivre avec la face revêtue sur un substrat céramique (3),
chauffage à une température de process du substrat céramique avec la plaque ou feuille de cuivre appliquée, de sorte qu'il y ait établissement d'une liaison par adhérence de la plaque ou feuille de cuivre et du substrat céramique, et
refroidissement de la combinaison du substrat céramique et de la plaque ou feuille de cuivre à la température ambiante,
la plaque ou feuille de cuivre étant structurée pour la formation des pistes de conduction pour le support du circuit avant l'application sur le substrat céramique ou en combinaison avec le substrat céramique.

2. Procédé selon la revendication 1, **caractérisé en ce que** l'application de la couche d'aluminium-magnésium ou la couche d'aluminium-silicium a lieu par plaquage par laminage sur la plaque ou feuille de cuivre.

3. Procédé selon la revendication 1 ou 2, **caractérisé en ce que** la température de process à laquelle le substrat céramique avec la plaque ou feuille de cuivre appliquée est réchauffé se situe entre 500 et 800 °C, de préférence entre 600 et 700 °C, en particulier 600 °C.

4. Procédé selon la revendication 3, **caractérisé en ce que** la plaque ou feuille de cuivre est structurée par découpe au laser ou par poinçonnage.

5. Procédé selon l'une des revendications 1 à 4, **caractérisé en ce que** le substrat céramique est un substrat Al₂O₃ ou un substrat Si₃N₄ ou bien un substrat AlN.

6. Procédé selon l'une des revendications 1 à 5, **caractérisé en ce que**, pour la fabrication de substrats métal-céramique métallisés double face avec une couche aluminium-magnésium ou une couche aluminium-silicium, des plaques ou feuilles de cuivre revêtues sont appliquées avec les faces revêtues sur les deux faces du substrat céramique.

7. Procédé selon l'une des revendications 1 à 6, **caractérisé en ce qu'**une couche d'aluminium-silicium (2) est appliquée sur la plaque ou feuille de cuivre (1).

8. Procédé selon l'une des revendications 1 à 6, **caractérisé en ce qu'**une couche d'aluminium-magnésium (2) est appliquée sur la plaque ou feuille de cuivre (1).
